# EUROPEAN PATENT APPLICATION

(11) **EP 1 017 141 A2**
(43) Date of publication of application: **05.07.2000**
(21) Application number: 99310572.5
(22) Date of filing: 24.12.1999
(51) Int. Cl.: H01S 5/026

(54) **Modulator-integrated laser module**

(30) Priority: 28.12.1998 JP 37450098
(71) Applicant: NEC CORPORATION, Tokyo (JP)
(72) Inventor: sato, Kazuyoshi, Minato-ku, Tokyo (JP)
(74) Representative: Moir, Michael Christopher

(57) **Abstract**

An electro-absorption modulator is integrated with a DFB semiconductor laser to form a modulator-integrated laser, and a modulated laser light emitted from the modulator-integrated laser is transmitted via an optical fiber. The electro-absorption modulator is provided with a spot size-converting region formed of a tapered waveguide, a width of which is slowly reduced in the horizontal direction from an incident end of the waveguide to the light-emitting end thereof. A spot size of the modulated laser light at a light-emitting end of the modulator-integrated laser is almost the same as that of the single mode optical fibre, hence both can be directly connected with a low coupling loss.

## Description

### FIELD OF THE INVENTION

The invention relates to a modulator-integrated laser module in which a distributed feed back (DFB, hereinafter) semiconductor laser and an electro-absorption modulator are mounted on the same substrate, and a modulated laser light is emitted from a light emitting end of the modulator-integrated laser and outputted to the outside via an optical fiber.

### BACKGROUND OF THE INVENTION

With the explosive spread of the internet, the transmission capacity necessary for the trunk line of the network is strikingly increasing. In conformity with the aforementioned recent tendency, the long haul wavelength division multiplexed (WDM, hereinafter) transmission system of a 1.55 µm band is widely adopted, and the modulator-integrated laser module in which the electro-absorption modulator is integrated with the DFB semiconductor laser (Japanese Patent Application laid-open No. 7·244330)is used as a light source for a long haul transmission system.

Because of the wide spread of the transmission apparatus, it becomes necessary to reduce the cost of this apparatus, hence the cost of the modulator-integrated laser module must also be significantly reduced.

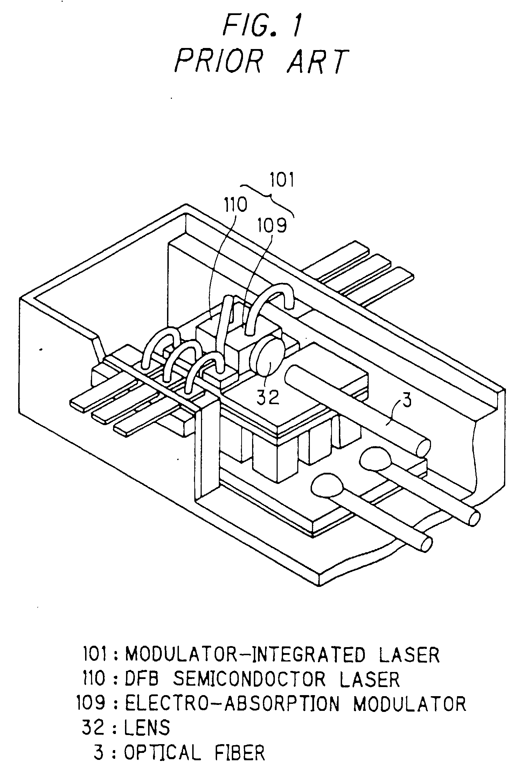

FIG.1 shows a structure of a conventional modulator-integrated laser module, in which a DFB semiconductor laser 110 and an electro-absorption modulator 109 are mounted on the same substrate to compose a modulator- integrated laser 101. The modulated laser light is emitted from an light-emitting end of the modulator-integrated laser 101, and outputted to the outside via an optical fiber 3.

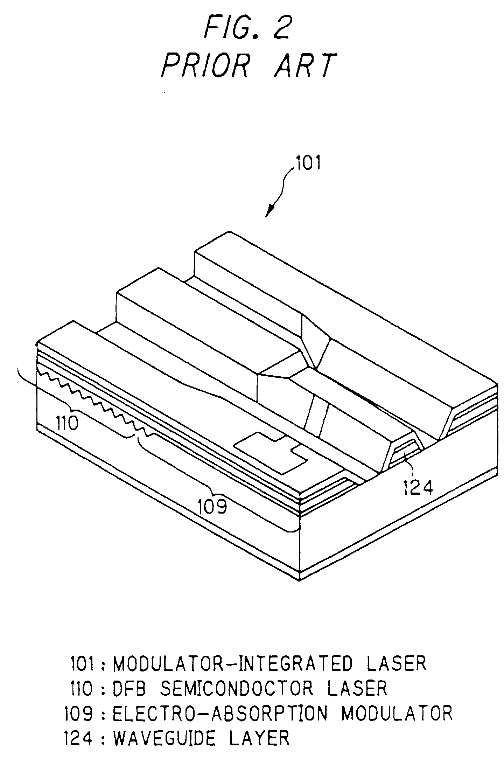

As shown FIG.2, in the conventional modulator -integrated laser 101. a width of a waveguide layer 124 of the electro-absorption modulator 109 is determined in conformity with a laising condition of the laser light, and the waveguide layer 124 is formed so that it is parallel with a direction in which the laser light is propagated.

In the aforementioned structure, a spot size of the light propagated through the electro-absorption modulator 109 is not small, and an aspect ratio of the emitted beam is large. Accordingly, if the modulator-integrated laser 101 is directly connected with a single mode optical fiber 3, a coupling loss therebetween becomes large. Then, in the conventional laser module, a light emitted from the modulator-integrated laser 101 is focused on an end face of the single mode optical fiber 3 by means of a lens 32, and the modulator-integrated laser 101 is optically coupled with the single mode optical fiber 3.

In the conventional laser module, since the modulator-integrated laser 101 is optically coupled with the single mode optical fiber 3 by means of the lens 32. the number of the components increases and it takes a long time to align optical axes.

### SUMMARY OF THE INVENTION

Accordingly, it is an object of at least the preferred embodiments of the invention to provide a modulator-integrated laser module which makes a lens and a time for aligning the optical axes thereof unnecessary.

According to the invention, a modulator-integrated laser module comprises:
a distributed feedback semiconductor laser for emitting a laser light mounted on a substrate,
an electro-absorption modulator which is integrated with the distributed feedback semiconductor laser on the same substrate, modulates the laser light, and emits the modulated laser light from a light-emitting end thereof, and
an optical fiber optically coupled with the light-emitting end of the electro-absorption modulator and conveying the modulated laser light,
wherein the electro-absorption modulator is provided with a spot size-converting region in which a cross-sectional dimension of a waveguide in the electro-absorption modulator for guiding the modulated laser light is slowly reduced from an incident end of the waveguide to the light-emitting end thereof.

In another aspect the invention provides in a modulated laser light optical fibre communication system, coupling a laser-light processing element of the system to an optical fibre by means of a waveguide of gradually varying cross-section as a substitute for a lens.

### BRIEF DESCRIPTION OF THE DRAWINGS

The invention will be explained in more detail in conjunction with appended drawings, wherein:
FIG. 1 is a perspective view for showing a conventional modulator-integrated laser module,
FIG. 2 is a perspective view for explaining a conventional modulator-integrated laser used in the aforementioned module,
FIG. 3 is a perspective view for showing a modulator-integrated laser module according to the first preferred embodiment of the invention,
FIG. 4 is a perspective view for showing a structure of a modulator-integrated laser used in the aforementioned module,
FIG.5 is a perspective view for explaining a structure of a modulator-integrated laser shown in FIG.4 by cutting it along a line III-III in FIG.4, and
FIG.6 is a perspective view for showing a modulator-integrated laser used in the second preferred embodiment of the invention.

### DESCRIPTION OF THE PREFERRED EMBODIMENT

Hereafter, a modulator-integrated laser module according to the invention will be explained referring to the appended drawings.

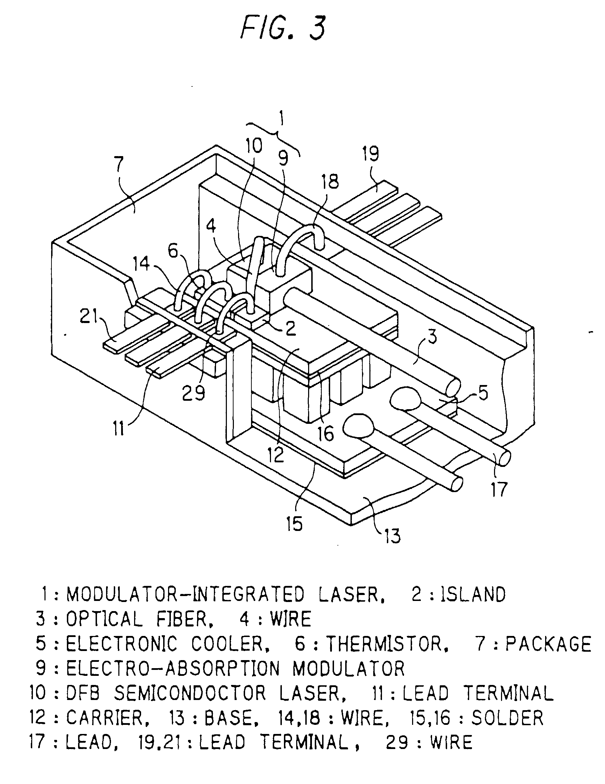

FIG.3 is a perspective view for showing a structure of a laser module according to the first preferred embodiment of the invention. The modulator-mounted laser module comprises a modulator-integrated laser 1 which is composed of a DFB semiconductor laser 10 and an electro-absorption modulator 9 mounted on the same substrate, and a modulated laser light ( not shown ) is emitted from the light-emitting end of the modulator-integrated laser 1 and outputted to the outside via an optical fiber 3.

A package 7 contains the modulator-integrated laser 1, an electronic cooler 5 for cooling the modulator-integrated laser 1, and a thermistor 6 for monitoring a temperature of the modulator-integrated laser 1; and is charged with nitrogen and gastight.

The modulator-integrated laser 1 is fixed to the carrier 12 by soldering. A bottom surface of the thermistor 6 is coated with solder, and fixed to a top surface of the carrier 12. A bottom surface of the electronic cooler 5 is fixed to a top surface of a base 13 of the package 7 by solder 15. A bottom surface of the carrier 12 is fixed to a top surface of the electronic cooler 5 by solder 16. The optical fiber 3 is fixed to the carrier 12 so that the light emitted from the modulator-integrated laser 1 launches the optical fiber 13.

Leads 17 of the electronic cooler 5 are electrically connected with lead terminals ( not shown ) of the package 7 to communicate with the outside. The semiconductor laser 10 is electrically connected with an island 2 via a wire 4 to communicate with the outside. Moreover, the island 2 is connected with lead terminals 11 via a wire 29. The electro-absorption modulator 9 is connected with a lead terminal 19 via a wire 18 to communicate with the outside. The thermistor 6 is electrically connected with a lead terminal 21 via a wire 14.

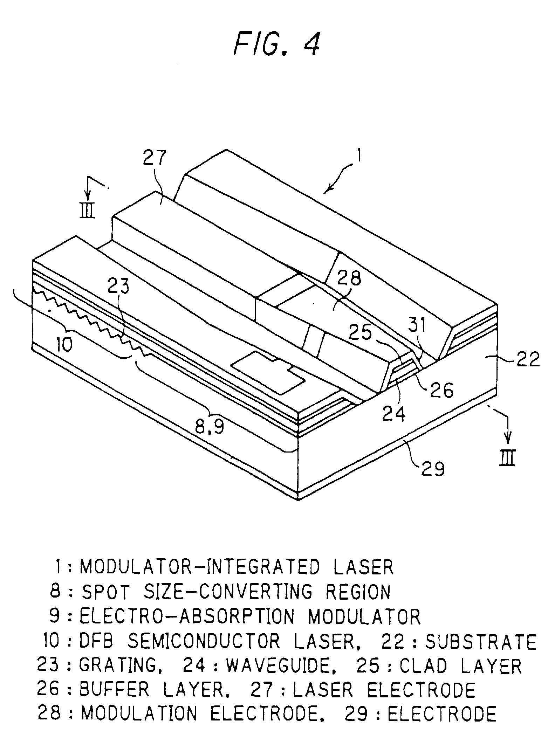

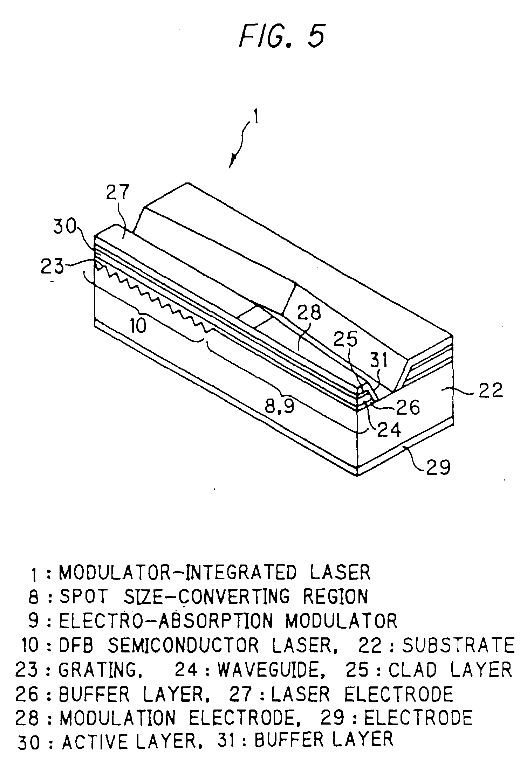

FIG.4 is a perspective view for showing a structure of the modulator-integrated laser 1, and FIG.5 is a perspective view for explaining the structure shown in FIG.4 by cutting it along a line III-III in FIG.4.

The modulator-integrated laser 1 is composed of the semiconductor laser 10 and the electro-absorption modulator 9. The semiconductor laser 10 is a DFB laser comprising a grating 23 formed on the substrate 22. In the semiconductor laser 10, an active layer 30 which corresponds to a laising wavelength of 1.55 µm and serves as both a light-emitting layer and a waveguide layer is inserted between a clad layer 25 and a buffer layer 26. When a driving current flows from a laser electrode 27 to an electrode 29, the semiconductor laser 10 is activated to emit a laser light therefrom.

In the electro-absorption modulator 9, the waveguide layer 24 is inserted between the clad layer 25 and the buffer layer 26, and a light absorption amount in the waveguide layer 24 is changed by applying a voltage between the modulation electrode 28 and the electrode 29.

The laser light emitted from the laser 10 is optically coupled with the waveguide layer 24 of the electro-absorption modulator 9, and is emitted therefrom after propagating through the waveguide layer 24. A modulated laser light is emitted from the electro-absorption modulator 9 by applying a modulation voltage between the modulation electrode 28 and the electrode 29.

As shown in FIGs.4 and 5, the electro-absorption modulator 9 is provided with a spot size-converting region 8 formed of the tapered waveguide 24, a width of which is slowly reduced in the horizontal direction ( in parallel with the substrate 22 ) from an incident end of the tapered waveguide 24- to a light-emitting end thereof, and thereby a radiation angle of the emitted light is narrowed. The aspect ratio of the light-emitting end of the waveguide 24 is optimized, so that the shape of the emitted beam is almost an ideal Gaussian distribution. Accordingly, as shown in FIG.4, even if the modulator-integrated laser 1 is directly connected with the single mode optical fiber 3 without a lens, a coupling loss therebetween is sufficiently low. In FIG.5, a buried layer is denoted by a reference numeral 31.

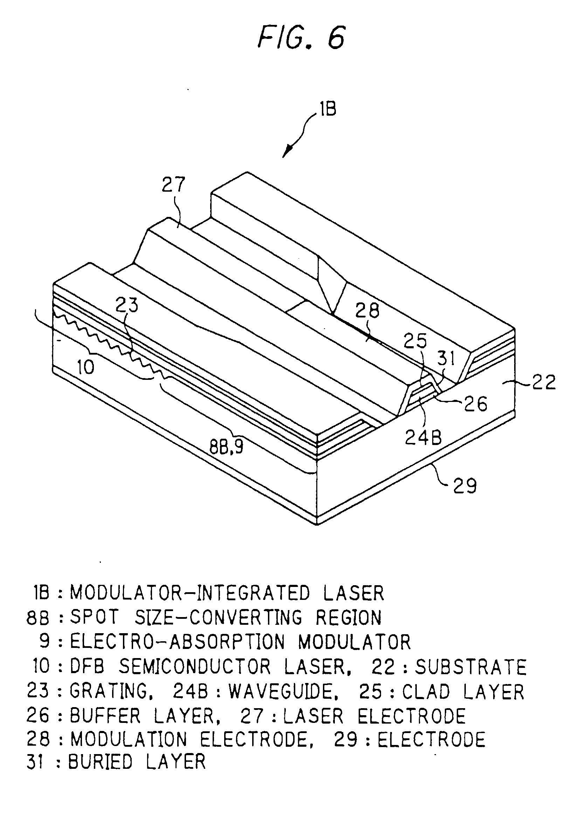

FIG.6 shows the other modulator-integrated laser 1B used in the second preferred embodiment of the invention. Although the horizontal width of the spot size-reducing region 8 is slowly reduced from the incided end of the waveguide to the light-emitting end thereof in the first preferred embodiment shown FIGs.3 to 5, the vertical width of the spot size-reducing region 8B is slowly reduced to narrow the beam width of the emitted light in the second preferred embodiment of the invention shown in FIG.6. The aspect ratio of the light-emitting end of the waveguide 24B is optimized, so that the shape of the emitted beam is almost an ideal Gaussian distribution. Similarly to the first preferred embodiment shown in FIG. 4, even if the modulator-integrated laser 1B is directly connected with the single mode optical fiber 3, a coupling loss therebetween is sufficiently low.

In the semiconductor laser module according to the invention, the electro-absorption modulator is integrated with the DFB semiconductor laser to form a modulator-integrated laser on the same substrate, and the moduleted laser light emitted from the modulator-integrated laser is supplied to the outside via the optical fiber. The electro-absorption modulator is provided with the spot size-converting region formed of a tapered waveguide, the width of which is slowly reduced in the horizontal or vertical direction from the incident end of the waveguide to the light emitting end thereof. The spot size of the modulated laser light at the light-emitting end of the modulator-integrated laser is almost the same as that of the single mode optical fiber, hence both can be directly connected with a low coupling loss. Accordingly, there is no necessity for using optical components such as a lens, the fabrication cost can be reduced, and the time necessary for alignments of optical axes can be cut down.

Although the invention has been described with respect to specific embodiment for complete and clear disclosure, the appended claims are not to be thus limited but are to be construed as embodying all modification and alternative constructions that may be occurred to one skilled in the art which fairly fall within the basic teaching here is set forth.

Each feature disclosed in this specification (which term includes the claims) and/or shown in the drawings may be incorporated in the invention independently of other disclosed and/or illustrated features.

Statements in this specification of the "objects of the invention" relate to preferred embodiments of the invention, but not necessarily to all embodiments of the invention falling within the claims.

The description of the invention with reference to the drawings is by way of example only.

The text of the abstract filed herewith is repeated here as part of the specification.

An electro-absorption modulator is integrated with a DFB semiconductor laser to form a modulator-integrated laser, and a modulated laser light emitted from the modulator-integrated laser is transmitted via an optical fiber. The electro-absorption modulator is provided with a spot size-converting region formed of a tapered waveguide, a width of which is slowly reduced in the horizontal direction from an incident end of the waveguide to the light-emitting end thereof. A spot size of the modulated laser light at a light-emitting end of the modulator-integrated laser is almost the same as that of the single mode optical fibre, hence both can be directly connected with a low coupling loss.

## Claims

1. A modulator-integrated laser module, comprising:
a distributed feedback semiconductor laser for emitting a laser light mounted on a substrate,
an electro-absorption modulator which is integrated with said distributed feedback semiconductor laser on said same substrate, modulates said laser light, and emits said modulated laser light from a light-emitting end thereof, and
an optical fiber optically coupled with said light-emitting end of said electro-absorption modulator and conveying said modulated laser light.
wherein said electro-absorption modulator is provided with a spot size-converting region in which a cross-sectional dimension of a waveguide in said electro-absorption modulator for guiding said modulated laser light is slowly reduced from an incident end of said waveguide to said light-emitting end thereof.

2. A modulator-integrated laser module according to claim 1, wherein:
said cross-sectional dimension of said waveguide is a width thereof in a direction in parallel with said substrate.

3. A modulator -integrated laser module according to claim 1, wherein:
said cross-sectional dimension of said waveguide is a width thereof in a direction vertical to said substrate.

4. In a modulated laser light optical fibre communication system, coupling a laser-light processing element of the system to an optical fibre by means of a waveguide of gradually varying cross-section as a substitute for a lens.
